# EUROPÄISCHE PATENTANMELDUNG

(11) **EP 0 655 628 A2**
(43) Veröffentlichungstag der Anmeldung: **31.05.1995**
(21) Anmeldenummer: 94118310.5
(22) Anmeldetag: 21.11.1994
(51) Int. Cl.: G01R 33/025, G01R 33/09

(54) **Integrierte Schaltung mit einem Magnetfeldsensor**

(30) Priorität: 30.11.1993 SI 9300622
(71) Anmelder: FAKULTETA ZA ELEKTROTEHNIKO IN RACUNALNISTVO, 61000 Ljubljana (SI)
(72) Erfinder: Trontelj, Janez, Prof. Dr., SI-61000 Ljubljana (SI); Opara, Roman, SI-61000 Ljubljana (SI); Pletersek, Anton, Dr., SI-61000 Ljubljana (SI)
(74) Vertreter: Lehn, Werner, Dipl.-Ing.

(57) **Zusammenfassung**

Integrierte Schaltung mit einem Magnetfeldsensor (MS), die zusammen mit einer sonstigen integrierten Schaltung auf einem Siliziumsubstrat (S) ausgeführt ist, umfaßt eine mit ihrer inneren Windung den Aktivbereich (A) des Magnetfeldsensors (MS) umgebende Flachspule (T), die in einer ersten Metallschicht (M1) über dem Siliziumsubstrat (S) ausgeführt ist. Die innere Windung der Flachspule (T) ist über vier symmetrisch gegenüber dem Magnetfeldsensor (MS) angeordnete innere Anschlußkontakte (K1) an einen Anschlußstreifen (SL1) angeschlossen. Die Außenwindung der Flachspule (T) ist über einen äußeren Anschlußkontakt (K2) an einen Anschlußstreifen (SL2) angeschlossen. Die Anschlußstreifen (SL1, SL2) sind in einer zweiten Metallschicht (M2) ausgeführt.

Die erfindungsgemäße Schaltung ermöglicht ein genaues Selbstkalibrieren der Empfindlichkeit und auch ein schnelles Selbsttesten. Weiterhin wird ein Kompensieren der Empfindlichkeitsveränderung mit Temperatur und Zeit sowie einer nicht-idealen Symmetrie der kreuzförmigen Ausführung des Magnetfeldsensors wie auch der Offsetspannung ermöglicht.

## Beschreibung

Die Erfindung betrifft eine integrierte Schaltung mit einem Magnetfeldsensor, in dessen Aktivbereich durch die integrierte Schaltung ein Referenzmagnetfeld erzeugt werden kann.

Es sind zahlreiche einen Magnetfeldsensor enthaltende integrierte Schaltungen bekannt. Es wird versucht, eine nichtideale Symmetrie der kreuzförmigen Ausführung des Magnetfeldsensors wie auch der Offsetspannung zu kompensieren, und zwar durch eine möglichst gleiche Ausführung der einander entsprechenden Elemente des Magnetfeldsensors oder durch geeignete Eigenschaften anderer Elemente in der integrierten Schaltung. Der Magnetfeldsensor wird getestet, indem ein Magnetfeld durch eine besondere und von der integrierten Schaltung getrennte Vorrichtung erzeugt wird. Bei bekannten einen Magnetfeldsensor enthaltenden integrierten Schaltungen wird der Nachteil bemerkbar, daß es nicht möglich ist, auf eine einfache Weise einen Defekt festzustellen und Langzeitveränderungen an dem Magnetfeldsensor bzw. an der ihn begleitenden elektronischen Schaltung automatisch zu korrigieren.

Durch die vorliegende Erfindung wird das Problem gelöst, eine solche einen Magnetfeldsensor enthaltende integrierte Schaltung zu schaffen, daß mit dieser Schaltung ein Referenzmagnetfeld zum schnellen Testen und Kalibrieren des Magnetfeldsensors, zum Kompensieren der Empfindlichkeitsveränderung mit Temperatur und Zeit und zum Kompensieren einer nichtidealen Symmetrie der kreuzförmigen Ausführung des Magnetfeldsensors sowie auch der Offsetspannung wird erzeugt werden können. Dabei soll der Magnetfeldsensor im Bereich normaler Speisespannungen dieselbe Wirksamkeit wie andere bekannte integrierte Magnetfeldsensoren besitzen.

Die genannte Aufgabe wird erfindungsgemäß durch die im Kennzeichen des Patentanspruchs 1 angegebenen Merkmale gelöst.

Die den Magnetfeldsensor enthaltende integrierte Schaltung nach der Erfindung ist gegenüber bekannten Schaltungen zuverlässiger, denn durch das Errichten des Magnetfeldes mittels einer eigenen Flachspule kann das Auftreten eines Fehlers schnell und einfach festgestellt werden. Durch das Magnetfeld der Flachspule wird eine Langzeitveränderung der Eigenschaften des Sensors sowie der begleitenden Elektronik automatisch korrigiert, wodurch die Zuverlässigkeit der integrierten Schaltung beschriebener Art erhöht wird.

Ein Ausführungsbeispiel der Erfindung ist in der Zeichnung dargestellt und wird im folgenden näher beschrieben.

Es zeigen:
- Fig. 1: eine schematische Darstellung in der Aufsicht auf die integrierte Schaltung nach der Erfindung mit einem Magnetfeldsensor,
- Fig. 2: eine schematische Darstellung im Querschnitt durch die integrierte Schaltung.

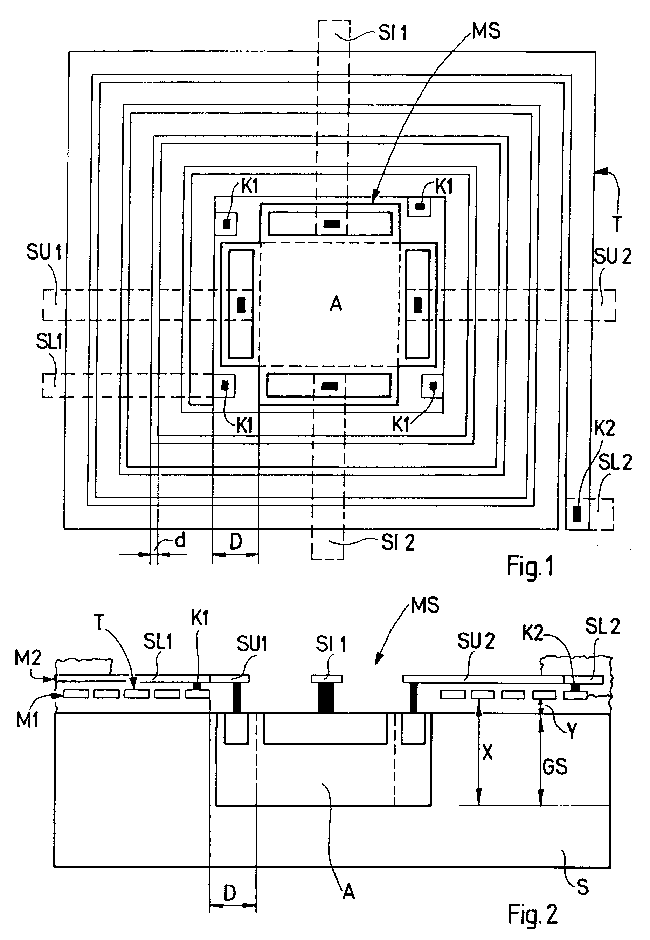

Die erfindungsgemäße einen Magnetfeldsensor MS enthaltende integrierte Schaltung ist in Fig. 1 in der Aufsicht und in Fig. 2 im Querschnitt schematisch dargestellt. Der Magnetfeldsensor MS in kreuzförmiger Ausführung ist auf eine sonst bekannte Weise auf einem Siliziumsubstrat S ausgeführt und mit Spannungsanschlußstreifen SU1, SU2 und mit Stromanschlußstreifen SI1, SI2 ausgestattet. Alle vier Anschlußstreifen sind in einer zweiten Metallschicht M2 ausgeführt, die über einer ersten Metallschicht M1 angeordnet ist und von dieser durch eine Oxidschicht getrennt wird. Diese und andere Oxidschichten werden in Fig. 1 und 2 übersichtlichkeitshalber nicht dargestellt.

In der ersten Metallschicht M1 ist eine Flachspule T ausgeführt, deren innere Windung im kleinsten technologisch erreichbaren Abstand D den Aktivbereich A des Magnetfeldsensors MS umgibt. Die innere Windung der Flachspule T ist über vier symmetrisch gegenüber dem Magnetfeldsensor MS, z. B. in den Bereichen zwischen den Schenkeln des Magnetfeldsensors MS in kreuzförmiger Ausführung, angeordnete innere Anschlußkontakte K1 an einen Anschlußstreifen SL1 angeschlossen. Die Windungen der Flachspule T sind in der ersten Metallschicht M1 so angeordnet, daß dazwischen jedesmal der kleinste technologisch erreichbare Abstand d besteht. Die genannten Anforderungen an die Abstände D und d müssen erfüllt sein, damit der Widerstand der Flachspule T möglichst klein ist. Die Außenwindung der Flachspule T ist über einen äußeren Anschlußkontakt K2 an einen Anschlußstreifen SL2 angeschlossen. Die dem Anschluß der Flachspule T an eine Stromquelle dienenden Anschlußstreifen SL1, SL2 sind in der zweiten Metallschicht M2 ausgeführt.

Um das Magnetfeld der Flachspule T am besten auszunützen, sind der Abstand Y der ersten Metallschicht M1 von der Oberfläche des Substrates S und die Tiefe GS des Aktivbereiches A des Magnetfeldsensors MS so klein wie möglich. Darum ist der Abstand X der ersten Metallschicht M1, also auch der Ebene der Flachspule T, von dem Grund des Aktivbereiches A so klein wie nur technologisch erreichbar. Dabei ist die Tiefe GS typischerweise annähernd gleich dem dreifachen Abstand Y. Die Flachspule T hat typischerweise 5 bis 10 Windungen, wobei die Windungszahl vor allem von der Ausdehnung des Magnetfeldsensors MS abhängig ist.

Mit dem Anschließen an die Stromquelle entsteht um die integrierte Flachspule T herum ein Referenzmagnetfeld, das in unmittelbarer Nähe der Flachspulenebene und also auch im Aktivbereich A senkrecht zu dieser Ebene gerichtet ist. Die Magnetflußdichte im Aktivbereich A wird durch die Parameter der Flachspule T und die Permeabilität des Siliziums genau bestimmt. Datum wird ein genaues Selbstkalibrieren und auch ein schnelles Testen der erfindungsgemäßen Schaltung möglich. In der erfindungsgemäßen Schaltung können durch die Erzeugung des geeigneten Magnetfeldes die Empfindlichkeitsveränderung des Magnetfeldsensors mit Temperatur und Zeit und eine nichtideale Symmetrie der kreuzförmigen Ausführung des Magnetfeldsensors MS sowie der Offsetspannung kompensiert werden. In dem Bereich normaler Speisespannungen eines Magnetfeldsensors hat die den Magnetfeldsensor enthaltende Schaltung dieselbe Wirksamkeit wie andere bekannte integrierte Magnetfeldsensoren.

## Patentansprüche

1. Integrierte Schaltung mit einem Magnetfeldsensor (MS), die zusammen mit einer sonstigen integrierten Schaltung auf einem Siliziumsubstrat (S) ausgeführt ist, dadurch gekennzeichnet,
daß eine mit ihrer inneren Windung den Aktivbereich (A) des Magnetfeldsensors (MS) umgebende Flachspule (T) in einer ersten Metallschicht (M1) über dem Siliziumsubstrat (S) ausgeführt ist,
und daß die innere Windung der Flachspule (T) über vier symmetrisch gegenüber dem Magnetfeldsensor (MS) angeordnete innere Anschlußkontakte (K1) an einen Anschlußstreifen (SL1) angeschlossen ist, der in einer zweiten oberhalb der ersten Metallschicht (M1) ausgeführten Metallschicht (M2) ausgeführt ist, und die Außenwindung der Flachspule (T) über einen Anschlußkontakt (K2) an einen in der zweiten Metallschicht (M2) ausgeführten Anschlußstreifen (SL2) angeschlossen ist.

2. Integrierte Schaltung nach Anspruch 1, dadurch gekennzeichnet,
daß die innere Windung der Flachspule (T) in dem kleinsten technologisch erreichbaren Abstand (D) den Aktivbereich (A) des Magnetfeldsensors (MS) umgibt.

3. Integrierte Schaltung nach Anspruch 2, dadurch gekennzeichnet,
daß der Abstand (X) der ersten Metallschicht (M1) vom Grund des Aktivbereiches (A) so klein wie nur technologisch erreichbar ist.

4. Integrierte Schaltung nach Anspruch 3, dadurch gekennzeichnet,
daß der Abstand (d) der Windungen der Flachspule (T) voneinander so klein wie nur technologisch erreichbar ist.
